(19) Europäisches Patentamt
European Patent Office
Office européen des brevets

(11) **EP 4 657 090 A1**

(12) **EUROPEAN PATENT APPLICATION**
published in accordance with Art. 153(4) EPC

(43) Date of publication:
**03.12.2025 Bulletin 2025/49**

(21) Application number: **24888917.2**

(22) Date of filing: **10.09.2024**

(51) International Patent Classification (IPC):
*G01R 31/367* (2019.01)   *G01R 31/36* (2020.01)
*G01R 31/392* (2019.01)   *G01R 31/396* (2019.01)
*G01R 31/385* (2019.01)   *H01M 10/42* (2006.01)
*H01M 10/48* (2006.01)    *B60L 58/16* (2019.01)

(52) Cooperative Patent Classification (CPC):
**H01M 10/48**

(86) International application number:
**PCT/KR2024/013676**

(87) International publication number:
**WO 2025/100721 (15.05.2025 Gazette 2025/20)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **09.11.2023  KR 20230154782
09.09.2024  KR 20240122639**

(71) Applicant: **LG Energy Solution, Ltd.
Seoul 07335 (KR)**

(72) Inventor: **CHOI, Geon
Daejeon 34122 (KR)**

(74) Representative: **Plasseraud IP
104 Rue de Richelieu
CS92104
75080 Paris Cedex 02 (FR)**

(54) **BATTERY MANAGEMENT SYSTEM AND BATTERY MANAGEMENT METHOD**

(57) A battery management system according to the present disclosure includes: memory; and a controller configured to execute a parameter acquisition procedure to determine respective latest values of a first parameter, a second parameter, and a third parameter associated with a current state of a battery. The controller is further configured to: call a parameter map from the memory, the parameter map recording a correspondence relationship of the third parameter relative to the first and second parameters; and execute a map update procedure to update the parameter map based on the respective latest values of the first, second, and third parameters.

**FIG. 1**

**Description**

<u>TECHNICAL FIELD</u>

The present disclosure relates to a battery management system and a battery management method.

This application is based on and claims priority from Korean Patent Application No. 10-2023-0154782, filed on November 9, 2023, and Korean Patent Application No. 10-2024-0122639, filed on September 9, 2024, with the Korean Intellectual Property Office, the disclosure of which is incorporated herein in its entirety by reference.

<u>BACKGROUND ART</u>

As the demand for portable electronic products such as laptops, video cameras, and portable phones has rapidly increased, and as the development of electric vehicles, energy storage batteries, robots, and satellites has begun in earnest recently, research on repeatedly chargeable/dischargeable high-performance batteries is actively underway.

Currently commercialized batteries include, for example, nickel cadmium batteries, nickel hydrogen batteries, nickel zinc batteries, and lithium batteries. Among these, as compared to the nickel-based batteries, the lithium batteries are in the spotlight because of their advantages including almost no memory effect, free charging and discharging, very low self-discharging rate, and high energy density.

Meanwhile, in order to manage the batteries and use them efficiently and stably, battery management systems (BMSs) are used. These BMSs monitor and maintain the batteries using parameters that directly or indirectly indicate the states of the batteries. Such parameters include voltage, current, and temperature. Much research is being conducted to address various issues associated with effectively managing these parameters.

<u>DISCLOSURE</u>

<u>Technical Problem</u>

The present disclosure provides a battery management system and a battery management method that update a parameter map used to determine a specific parameter, based on the value of a specific parameter determined by a parameter determination logic.

The present disclosure may be understood through the following description and will become more apparent through the embodiments of the present disclosure. It will also be understood that the present disclosure can be implemented by features set forth in the claims and combinations thereof.

<u>Technical Solution</u>

A battery management system according to an aspect of the present disclosure includes: a memory; and a controller configured to execute a parameter acquisition procedure to determine respective latest values of a first parameter, a second parameter, and a third parameter associated with a current state of a battery. The controller is configured to call, from the memory, a parameter map recording a correspondence relationship of the third parameter relative to the first and second parameters. The controller is configured to execute a map update procedure to update the parameter map based on the respective latest values of the first, second, and third parameters.

The controller may be configured to determine one of multiple storage locations of the parameter map as a target storage location based on the respective latest values of the first and second parameters. The controller may be configured to update a target map value of the third parameter recorded at the target storage location based on the latest value of the third parameter.

The controller may be configured to determine a target correction value based on the difference between the latest value of the third parameter and the target map value. The controller may be configured to update the target map value by summing the target correction value with the target map value.

The controller may be configured to determine the target correction value by multiplying a reference coefficient and a target correction coefficient by the difference between the latest value of the third parameter and the target map value.

The reference coefficient and the target correction coefficient may each be a predetermined positive number.

The controller may be configured to determine at least one of the multiple storage locations, other than the target storage location, as an expansion storage location. The controller may be configured to update an expansion map value of the third parameter recorded at the expansion storage location based on the latest value of the third parameter and the updated target map value.

The controller may be configured to determine an expansion correction value based on the difference between the latest value of the third parameter and the updated target map value. The controller may be configured to update the expansion map value by summing the expansion correction value with the expansion map value.

The controller may be configured to determine the expansion correction value by multiplying the reference coefficient and the expansion correction coefficient by the difference between the latest value of the third parameter and the updated target map value.

The reference coefficient may be a predetermined positive value. The controller may be configured to determine the expansion correction coefficient based on the latest value of the first parameter, an index value of the first parameter associated with the expansion map value, the latest value of the second parameter, and an index value of the second parameter associated with the expansion map value.

The first parameter may be a state of charge (SOC), the second parameter may be a temperature, and the third parameter may be an internal resistance.

A battery pack according to another aspect of the present disclosure includes the battery management system.

An electric vehicle according to yet another aspect of the present disclosure includes the battery pack.

A battery management method according to yet another aspect of the present disclosure includes: executing a parameter acquisition procedure to determine respective latest values of a first parameter, a second parameter, and a third parameter associated with a current state of a battery; calling, from a memory, a parameter map recording a correspondence relationship of the third parameter relative to the first and second parameters; and executing a map update procedure to update the parameter map based on the respective latest values of the first, second, and third parameters.

The updating the parameter map may include: determining one of multiple storage locations in the parameter map as a target storage location, based on the respective latest values of the first and second parameters; and updating the target map value of the third parameter recorded at the target storage location, based on the latest value of the third parameter.

The updating the parameter map may include: determining at least one of the multiple storage locations, other than the target storage location, as an expansion storage location; and updating an expansion map value of the third parameter recorded at the expansion storage location based on the latest value of the third parameter and the updated target map value.

A non-transitory computer-readable storage medium according to still another aspect of the present disclosure stores a program that when executed, causes a system to perform a method including: storing, in a memory, a parameter map recording a correspondence relationship of a third parameter relative to a first parameter and a second parameter of a battery; executing a parameter acquisition procedure to determine respective latest values of the first parameter, the second parameter, and the third parameter associated with a current state of a battery; calling the parameter map from the memory; and updating the parameter map based on the respective latest values of the first, second, and third parameters.

In the updating the parameter map, one of multiple storage locations in the parameter map may be determined as a target storage location, based on the respective latest values of the first and second parameters, and the target map value of the third parameter recorded at the target storage location may be updated based on the latest value of the third parameter.

In the updating the parameter map, a target correction value may be determined based on a difference between the latest value of the third parameter and the target map value, and the target map value may be updated by summing the target correction value with the target map value.

Advantageous Effects

According to at least one of the embodiments of the present disclosure, a parameter map used for determining a specific parameter may be updated based on the value of a specific parameter determined by a parameter determination logic.

In addition, according to at least one of the embodiments of the present disclosure, when executing the update procedure for a parameter map related to a specific parameter, a specific map value of a parameter map mapped to the latest values of other parameters, as well as at least one other map value recorded in the parameter map may be expansively updated.

The effects of the present disclosure are not limited to those mentioned above, and other effects not mentioned above will be clearly understood by a person ordinarily skilled in the art from the description of the claims.

DESCRIPTION OF DRAWINGS

The following drawings attached hereto exemplify embodiments of the present disclosure and, together with the detailed description to be described later, serve to further understand the technical idea of the present disclosure. Therefore, the present disclosure should not be construed as being limited to the matters illustrated in the drawings.

FIG. 1 is a diagram exemplarily illustrating an example configuration of an electric vehicle according to the present disclosure.

FIG. 2 illustrates an example of a parameter map in the form of a table.

FIG. 3 is a schematic view referenced to explain a map update procedure applied to the parameter map illustrated in FIG. 2.

FIG. 4 is a three-dimensional (3D) graph exemplified to compare two parameter maps before and after the update.

FIG. 5 is a 3D graph representing the differences between map values before and after the update.

FIGS. 6 and 7 are schematic views referenced to explain an update procedure for individual map values of the parameter map illustrated in FIG. 2.

FIG. 8 is an example of a three-dimensional graph representing an expansion coefficient map used for updating individual map values.

FIG. 9 is a flowchart schematically illustrating a battery management method according to another embodiment of the present disclosure.

FIG. 10 is a flowchart schematically illustrating subroutines that may be executed in step S930 of FIG. 9.

In some of the accompanying drawings, corresponding components are given the same reference numerals. A person ordinarily skilled in the art will appreciate that the drawings illustrate elements simply and clearly and are not necessarily drawn to scale. For example, in order to aid understanding of various embodiments, the dimensions of some elements illustrated in the drawings may be exaggerated compared to other elements. In addition, elements that are useful or essential in commercially implementable embodiments but are known in the art may often not be described in order to avoid impeding the understanding of the spirit of various embodiments of the present disclosure.

BEST MODE

Hereinafter, embodiments of the present disclosure will be described with reference to the attached drawings. Prior to this, the terms and words used in the specification and claims should not be construed as limited to their ordinary or dictionary meanings, but should be interpreted with meanings and concepts consistent with the technical idea of the present disclosure based on a principle that the inventor may appropriately define the concepts of terms in order to explain his or her invention in the best way.

Accordingly, since the embodiments described in this description and the configurations illustrated in the drawings are merely exemplary embodiments of the present disclosure, and do not represent all of the technical ideas of the present disclosure, it should be understood that at the time of filing, there may be various equivalents and modifications that could serve as alternatives to the embodiments.

Terms containing ordinal numbers, such as "first" and "second", are used to distinguish one from another among various components and are not intended to limit or define the components with such terms.

Throughout the specification, when a part is described as "including" a certain component, it means that, unless there is specific contrary wording, it does not exclude other components, but rather indicates that other components may be further included. In addition, a term, such as "controller", as described in the specification, refers to a unit that processes at least one function or operation and may be implemented in hardware, software, or a combination of both.

In addition, throughout the specification, when a part is described as being "connected" to another part, this includes not only the case where the parts are "directly connected," but also the case where the parts are "indirectly connected," with another element interposed therebetween.

A battery management system that manages a battery may store a parameter map representing the correlations between multiple parameters, which directly or indirectly indicate the state of the battery. By using the parameter maps, various advantages may be achieved, such as reducing the calculation load required to directly calculate the values of specific parameters.

As a battery deteriorates over time, its characteristics gradually change. Therefore, the correlations between parameters when the battery was in a new condition may no longer be useful once the battery deviates from that condition. Accordingly, a procedure to appropriately calibrate and update the parameter maps in accordance with the deterioration of the battery is necessary.

Meanwhile, both the parameter maps and separate parameter determination logics may be used concurrently to determine the values of specific parameters. However, conventionally, even when the value of a specific parameter is determined (or learned) by a parameter determination logic, methods to sufficiently reflect the specific parameter value to other value(s) of the parameter map did not exist. For example, even when the value of a specific parameter is determined at a time where the State of Charge (SOC) is 50% and the temperature is 45°C by a separate parameter determination logic, the value of the specific parameter recorded in the storage location mapped to the same condition (SOC) 50% and temperature 45°C within the parameter map remains unchanged. Furthermore, the values recorded in other storage locations of the parameter map also remain unchanged.

Moreover, when an event such as the battery management system being powered off occurs, there is a problem, in that the value of a specific parameter determined by the parameter determination logic is discarded.

The present disclosure provides a battery management system and method capable of updating a parameter map used for determining a specific parameter based on the value of a specific parameter determined (or learned) by a parameter determination logic, considering the aforementioned problems.

In addition, the present disclosure provides a battery management system and method capable of, in executing the procedure for updating the parameter map related to a specific parameter, not only updating the specific map value in the parameter map mapped to the latest values of other parameters but also expansively updating at least one other map value recorded in the parameter map.

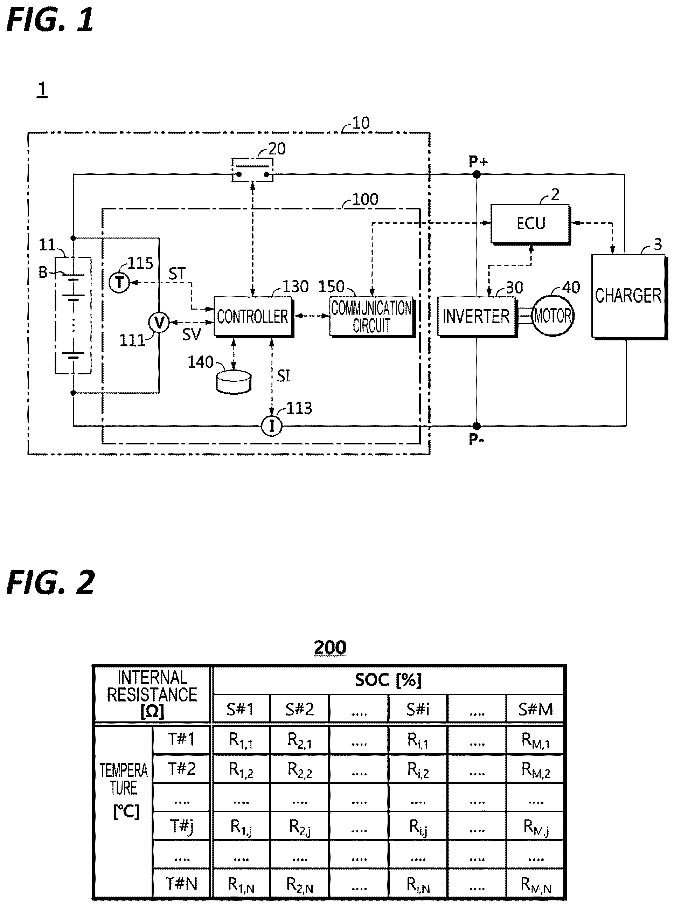

FIG. 1 is a diagram illustrating an example configuration of an electric vehicle, which employs the battery management system according to the present invention.

Referring to FIG. 1, an electric vehicle 1 includes a vehicle controller 2 (e.g., an electronic controller (ECU)), a battery pack 10, a relay 20, an inverter 30, and an electric motor 40. The charge/discharge terminals (P+, P-) of the battery pack 10 may be electrically connected to a charger 3 via, for example, a charging cable. The charger 3 may either be included in the electric vehicle 1 or be provided at a charging station.

The vehicle controller 2 is configured to send a key-ON signal to a battery management system 100 installed in the battery pack 10 in response to the start button (not illustrated) of the electric vehicle 1 being switched to the ON position by a user. The battery pack 10 may also include a battery group 11. The vehicle controller 2 is also configured to send a key-OFF signal to the battery management system 100 in response to the start button being switched to the OFF position by the user. The charger 3 may communicate with the vehicle controller 2 to supply constant current or constant voltage charging power through the charge/discharge terminals (P+, P-) of the battery pack 10.

The battery group 11 includes at least one battery B. The battery B may be a secondary battery, and its type is not particularly limited, as long as it is capable of repeated charging and discharging.

When the battery group 11 includes multiple batteries B, these batteries B may be interconnected in series, in parallel, or in a combination of series and parallel.

The relay 20 is electrically connected in series with the battery group 11 through a power path connecting the battery group 11 and the inverter 30. In FIG. 1, the relay 20 is exemplified as being connected between the positive terminal of the battery group 11 and the charge/discharge terminal (P+). The relay 20 is ON/OFF-controlled in response to a switching signal from the battery management system 100. According to an embodiment, the relay 20 may be a mechanical contactor that turns ON or OFF by the magnetic force of a coil or a semiconductor switch such as a metal oxide semiconductor field effect transistor (MOSFET).

The inverter 30 is provided to convert direct current (DC) from the battery group 11 into alternating current (AC), in response to a command from the battery management system 100 or the vehicle controller 2.

The electric motor 40 is driven using the alternating current power from the inverter 30. According to an embodiment, a three-phase AC motor may be used as the electric motor 40.

The battery management system 100 includes a voltage detector 111, a current detector 113, a temperature detector 115, and a controller 130. The battery management system 100 may further include a communication circuit 150.

The voltage detector 111 is connected to the positive and negative terminals of the battery B included in the battery group 11, to detect the terminal voltage across the battery B, and is configured to output a voltage signal SV representing the detected terminal voltage to the controller 130.

The current detector 113 is connected in series with the battery group 11 through the current path between the battery group 11 and the inverter 30. The current detector 113 is configured to: detect the charge/discharge current flowing through the battery group 11, and output a current signal SI representing the detected charge/discharge current to the controller 130. According to an embodiment, the current detector 113 may be implemented as one or a combination of current detection elements such as a shunt resistor and a Hall effect element.

The temperature detector 115 is configured to: measure the temperature of the battery B, and output a temperature signal ST representing the measured temperature to the controller 130. According to an embodiment, the temperature detector 115 may be implemented as one or a combination of two or more temperature measurement elements such as a thermocouple, a thermistor, and a bimetal.

The voltage detector 111, the current detector 113, and the temperature detector 115, may collectively be referred to as "sensing circuitry."

The communication circuit 150 is configured to support wired or wireless communication between the controller 130 and the vehicle controller 2. According to an embodiment, the wired communication may be controller area network (CAN) communication, and the wireless communication may be Zigbee or Bluetooth communication. The type of communication protocol is not particularly limited as long as it supports wired or wireless communication between the controller 130 and the vehicle controller 2. The communication circuit 150 may include an output device (*e.g.*, a display or a speaker) that provides information received from the controller 130 and/or the vehicle controller 2 in a form recognizable to the user.

In the battery management system 100, the controller 130 is operatively coupled to the relay 20, the voltage detector 111, the current detector 113, the temperature detector 115, and the communication circuit 150. The description "two components being operatively coupled" means that the two components are directly or indirectly connected in such a way that signals can be transmitted and received therebetween, either unidirectionally or bidirectionally.

The controller 130 may collect the voltage signal SV from the voltage detector 111, the current signal SI from the current detector 113, and/or the temperature signal ST from the temperature detector 115. The controller 130 may convert and record each analog signal collected from the detectors 111, 113, and 115 into digital values using, for example, an internal analog to digital converter (ADC).

The controller 130 may be referred to as a "control circuit" or a "battery controller" and may be implemented in hardware using application specific integrated circuits (ASICs), digital signal processors (DSPs), digital signal processing devices (DSPDs), programmable logic devices (PLDs), field programmable gate arrays (FPGAs), microprocessors, or other function-performing electrical units.

Memory 140 may include at least one type of storage medium selected from flash memory, hard disk, solid state disk (SSD), silicon disk drive (SDD), multimedia card micro, random access memory (RAM), static random access memory (SRAM), read-only memory (ROM), electrically erasable programmable read-only memory (EEPROM), and programmable read only memory (PROM). The memory 140 may store data and programs required for calculation operations by the controller 130. The memory 140 may store data representing the results of calculation operations by the controller 130. Although the memory 140 is illustrated in FIG. 1 as being physically independent from the controller 130, it may also be integrated into the controller 130.

The controller 130 may turn ON the relay 20 in response to a key-ON signal. The controller 130 may turn OFF the relay 20 in response to a key-OFF signal. The key-OFF signal indicates a transition from a cycling mode to a dormant mode. Alternatively, the vehicle controller 2 may be responsible for the ON/OFF control of the relay 20, rather than the controller 130.

While the relay 20 is turned ON, the battery B of the battery group 11 enters the cycling mode. The cycling mode refers to an operational state in which the charging and discharging of the battery group 11 are possible.

While the relay 20 is turned OFF, the battery B of the battery group 11 enters the dormant mode. The dormant mode refers to an operational state in which the charging and discharging of the battery group 11 are blocked and thus, charging and discharging of the batteries of the battery group is not possible.

The controller 130 may determine (estimate) the state of charge (SOC) of the battery B based on each of the voltage, current, and temperature measurements of the battery B, which are derived from the voltage signal SV, current signal SI, and temperature signal ST, respectively, while the battery group 11 is in the cycling mode. The SOC represents the ratio of the remaining capacity to the full charge capacity (maximum capacity) of the battery B.

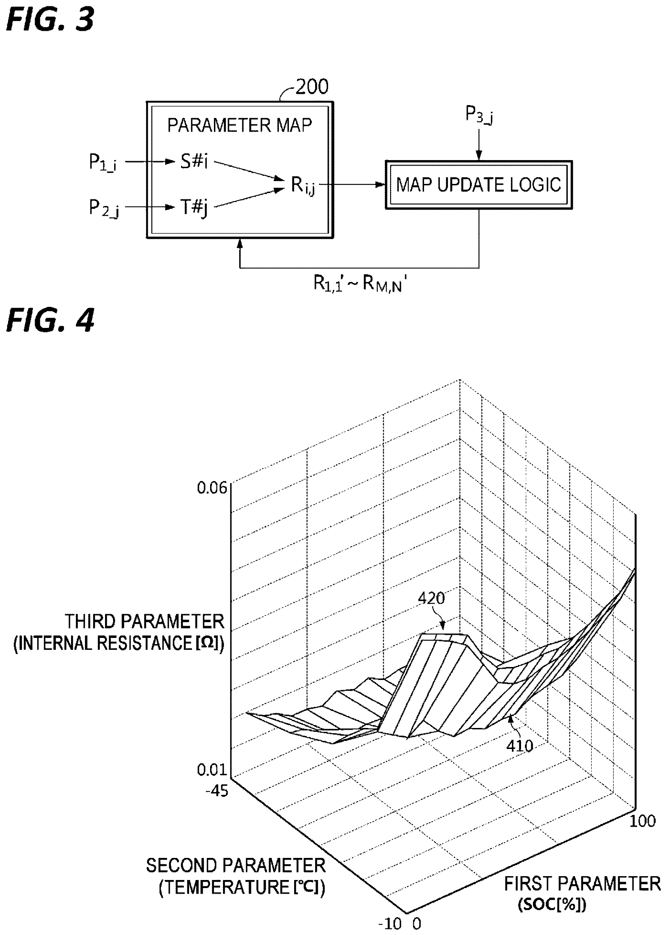

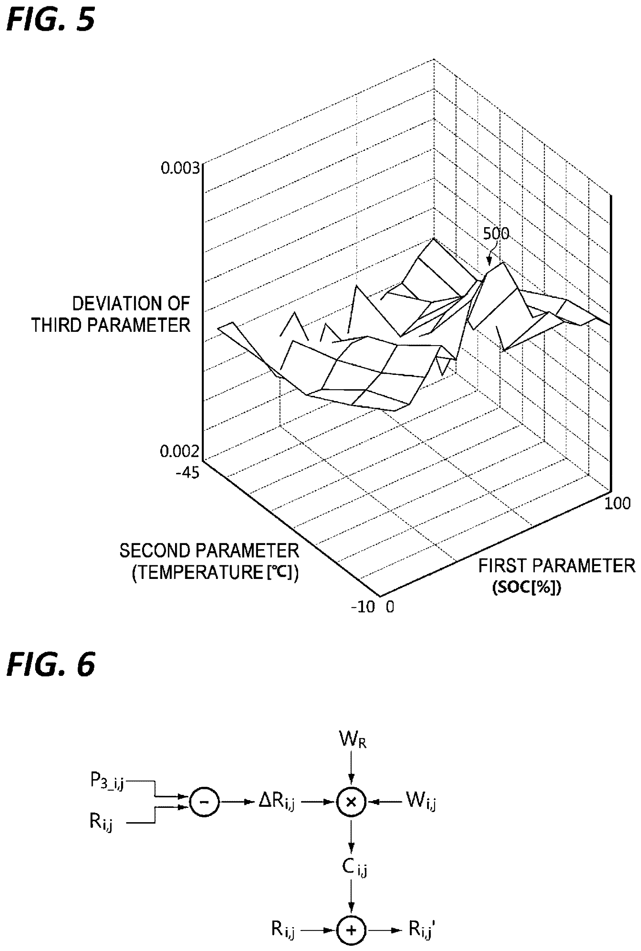

FIG. 2 illustrates an example of a parameter map in the form of a table, FIG. 3 is a schematic view referenced to explain a map update procedure applied to the parameter map illustrated in FIG. 2, FIG. 4 is a 3D graph used to compare two parameter maps before and after the update procedure, and FIG. 5 is a 3D graph representing the differences between map values before and after the update procedure.

The parameter map 200 exemplified in FIG. 2 records the correlation of a third parameter of the battery B with respect to the first and second parameters of the battery B. According to an embodiment, the parameter map 200 may be pre-stored in the memory 140.

At least one of the first and second parameters may be predetermined as a universal parameter that may be commonly used to indicate the state of all types of batteries, without being directly related to the inherent characteristics of the battery B. For example, measurable parameters such as temperature, voltage, and current fall under the category of universal parameters. In another example, parameters such as state of charge (SOC) and state of health (SOH), which are determined by applying mathematical operations to at least one measurable parameter, also fall under the category of universal parameters.

Unlike the first and second parameters, the third parameter may be predetermined from among the characteristic parameters that represent the inherent characteristics of the battery B. For example, internal resistance that represents the electrochemical characteristics of the battery B falls under the category of the characteristic parameters.

The first, second, and third parameters indicate the state of the battery B and may be directly or indirectly related to each other. As an example, one of the SOC, temperature, and internal resistance, may be set as the first parameter, another as the second parameter, and the remaining one as the third parameter. Even when the SOC remains constant, the internal resistance of the battery B tends to increase as the temperature decreases within a certain temperature range. In addition, even when the temperature remains constant, the internal resistance of the battery B tends to increase as the SOC increases within a predetermined SOC range. Hereinafter, for the convenience of explanation, it is assumed that the first parameter is SOC, the second parameter is temperature, and the third parameter is internal resistance.

The controller 130 may determine the target map value of the third parameter from the parameter map 200 by using the latest values of the first and second parameters as indices.

The parameter map 200 may have multiple storage locations, and each storage location may individually record multiple map values. The target map value of the third parameter may be one of the values recorded in the storage location determined by two index values corresponding to the latest values of the first and second parameters, respectively, among all of the values recorded in the parameter map 200.

Referring to FIGS. 2 and 3, multiple index values may be assigned to each of the first and second parameters in the parameter map 200. For example, assuming that M and N are natural numbers of 2 or more, which may be equal to or different from each other, the entire numerical range of the first parameter may be divided by the first to M-th index values (S#1 to S#M), and the entire numerical range of the second parameter may be divided by the first to N-th index values (T#1 to T#N). In this case, the parameter map 200 has first to MN-th storage locations, and the first to MN-th map values ($R_{1,1}$ to $R_{M,N}$) are recorded in the corresponding storage locations.

Therefore, when the latest values ($P_{1\_i}$, $P_{2\_j}$) of each of the first and second parameters are given, the controller 130 may identify (determine) one storage location among the first to MN-th storage locations in the parameter map 200, which is specified by the pair of the given values ($P_{1\_i}$, $P_{2\_j}$), as the target storage location. Subsequently, the controller 130 may read out the map value, which is the value of the third parameter recorded in the target storage location. The map value read from the target storage location may be referred to as a "target map value."

For example, assuming that i is a natural number less than or equal to M, and j is a natural number less than or equal to N, the controller 130 may identify the i-th index value (S#i), which has the smallest difference from the latest value ($P_{1\_i}$) of the first parameter, from among the first to M-th index values (S#1 to S#M) for the first parameter and the j-th index value (T#j), which has the smallest difference from the latest value ($P_{2\_j}$) of the second parameter, from among the first to N-th index values (T#1 to T#N) for the second parameter. For reference, the index number associated with the i-th index value (S#i) is i, and the index number associated with the j-th index value (T#j) is j.

Identifying the i-th index value (S#i) for the first parameter and the j-th index value (T#j) for the second parameter means that the ij-th storage location among the first to MN-th storage locations is identified. The ij-th storage location may be referred to as a "target storage location." Accordingly, the controller 130 may determine the ij-th map value ($R_{i,j}$) among the first to MN-th map values as the target map value. For reference, if M is 15, N is 5, i is 2, and j is 3, then the product of M and N (i.e., MN) is 75, and the product of i and j (i.e., ij) is 6.

The controller 130 may use the target map value ($R_{i,j}$) as an input variable for the map update logic. The latest value ($P_{3\_i,j}$) of the third parameter may be used as another input variable for the map update logic.

The latest values ($P_{1\_i}$, $P_{2\_j}$, $P_{3\_i,j}$) of the first, second, and third parameters may be the most recently measured or calculated values. For example, the SOC as the first parameter may be calculated in real-time or quasi-real-time by the controller 130 through, for example, ampere counting, extended Kalman filter, or open circuit voltage (OCV)-SOC relationship data. In another example, the temperature, as the second parameter, may be measured in real-time or quasi-real-time by a sensor (the temperature detector 115) at a predetermined sampling rate. In addition to temperature, voltage and current may also be measured in real-time or quasi-real-time by sensors (the voltage detector 111 and the current detector 113) at a predetermined sampling rate. As another example, the internal resistance as the third parameter may be calculated in real-time or quasi-real-time by the controller 130 using Ohm's Law based on the voltage and current measurements. Of course, the methods of determining the latest values of the first to third parameters are not limited to the aforementioned examples and may be replaced by various other methods.

Regarding the third parameter, the method using the parameter map 200 has the advantage of lower calculation load compared to the method using a separate estimation logic.

While operating in the normal mode, the controller 130 may determine the map value read from the parameter map 200 based on the latest values of the first and second parameters, as the third parameter value. In contrast, when a predetermined map update event occurs, the controller 130 may execute a separately prepared parameter estimation logic (*e.g.,* an equation based on Ohm's Law) instead of using the parameter map 200, to determine the latest value ($P_{3\_i,j}$) of the third parameter. The predetermined map update event may occur, for example, when the SOH of the battery B reaches predetermined reference values (e.g., 98%, 96%, and 94%).

When the map update logic is executed, the controller 130 may update at least one of the first to MN-th map values ($R_{1,1}$ to $R_{M,N}$) recorded in the parameter map 200 based on the target map value ($R_{i,j}$) and the latest value ($P_{3\_i,j}$) of the third parameter. Here, the latest value ($P_{3\_i,j}$) is the value obtained through the estimation logic (e.g., the equation based on Ohm's Law), and the target map value ($R_{i,j}$) is the value specified in the parameter map 200.

In FIG. 3, the symbols $R_{1,1}'$ to $R_{M,N}'$ represent the individual update results of $R_{1,1}$ to $R_{M,N}$ as a result of the execution of the map update logic. For example, through the process of the aforementioned map update logic, the pre-update value (e.g., $R_{i,j}$) in the parameter map 200 may be replaced with the post-update value ($R_{i,j}'$).

In FIG. 4, reference numeral 410 denotes a three-dimensional graph representing the relationship between the first parameter, second parameter, and third parameter recorded in the parameter map 200 before update procedure. Reference numeral 420 denotes a three-dimensional graph representing the relationship between the first parameter, the second parameter, and the third parameter, recorded in the parameter map 200 after update procedure.

In FIG. 5, reference numeral 500 denotes a three-dimensional graph representing the individual deviations between the map values ($R_{1,1}$ to $R_{M,N}$) recorded in the three-dimensional graph 410 of the parameter map 200 and the map values ($R_{1,1}$' to $R_{M,N}$') recorded in the three-dimensional graph 420 of the parameter map 200. These individual deviations may be considered to result from the characteristic changes, due to the degradation of the battery B.

It is widely known that a battery B gradually degrades over its lifecycle and that the characteristics of the battery B change due to degradation. In other words, the relationship between the first to third parameters may also gradually change due to degradation. Therefore, if the update process for the parameter map 200 is not executed, the value of the third parameter determined from the parameter map 200 may significantly deviate from the actual value of the third parameter, which reflects the changed characteristics of the battery B. The inventor of the present disclosure has recognized the advantageous effect that when a predetermined map update event occurs, for example, when the SOH of the battery B reaches a specific value, the parameter map 200 may be updated based on the latest value of the third parameter determined using a separate estimation logic, instead of the parameter map 200, thereby faithfully reflecting the characteristic changes, due to the degradation of the battery B in the parameter map 200.

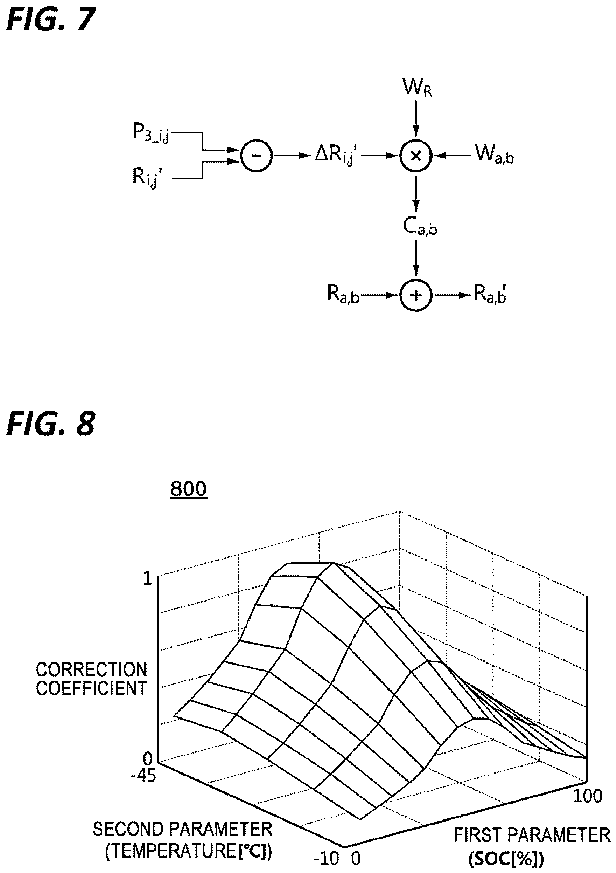

FIGS. 6 and 7 are schematic views referenced to explain the update procedure for the individual map values of the parameter map 200 represented in FIG. 2, and FIG. 8 is a view illustrating an example of a three-dimensional graph illustrating the expansion coefficient map used in the update of the individual map values.

FIG. 6 illustrates an update procedure for the target map value of the parameter map 200. Referring to FIG. 6, the controller 130 determines the target deviation ($\Delta R_{i,j}$), which is the difference between the latest value ($P_{3\_i,j}$) of the third parameter and the target map value ($R_{i,j}$) of the parameter map 200. The controller 130 may determine a target correction value ($C_{i,j}$) by multiplying the target deviation ($\Delta R_{i,j}$) by a reference coefficient ($W_R$) and a target correction coefficient ($W_{i,j}$). The reference coefficient ($W_R$) may be a predetermined positive value. The target correction coefficient ($W_{i,j}$) may either be a predetermined value or a value determined by the controller 130. Then, the controller 130 may determine the updated target map value ($R_{i,j}$') by summing the target map value ($R_{i,j}$) and the target correction value ($C_{i,j}$). Through this process, the value recorded at the ij-th storage location in the parameter map 200 may be updated from $R_{i,j}$ to $R_{i,j}$'.

FIG. 7 illustrates an update procedure of expansion map values. Assuming that a is a natural number less than or equal to M, b is a natural number less than or equal to N, and a is different from i or b is different from j, the controller 130 of the battery management system 100 may determine the storage location ab, which is different from the storage location ij, as an expansion storage location. The controller 130 may determine the map value ($R_{a,b}$) recorded at an expansion storage location as the expansion map value to be subjected to an additional update.

Referring to FIG. 7, the controller 130 of the battery management system 100 determines the target deviation ($\Delta R_{i,j}$'), which is the difference between the latest value ($P_{3\_i,j}$) of the third parameter and the updated target map value ($R_{i,j}$'). The controller 130 may determine the expansion correction value ($C_{a,b}$) by multiplying the target deviation ($\Delta R_{i,j}$') by the reference coefficient ($W_R$) and the expansion correction coefficient ($W_{a,b}$). The determination of the expansion correction coefficient ($W_{a,b}$) will be further described later with reference to FIG. 8. The controller 130 may then determine the updated expansion map value ($R_{a,b}$') by summing the expansion map value ($R_{a,b}$) and the expansion correction value ($C_{a,b}$). As a result, the map value recorded at the ab-th storage location in the parameter map 200 may be updated from $R_{a,b}$ to $R_{a,b}$'.

FIG. 8 illustrates an example of a three-dimensional graph representing a correction coefficient map 800 output through simulation. In FIG. 8, the two axes (*e.g.*, the X-axis and Y-axis) for the first parameter and the second parameter, respectively, may be the same as in FIGS. 4 and 5, while the remaining axis (e.g., the Z-axis) represents the correction coefficient. For example, according to an embodiment, the axes of the map are composed of "SOC" as the first parameter and "temperature" as the second parameter, and correction coefficients are determined according to a multivariate normal distribution. For example, when the preset mean/variance values of SOC and the mean/variance values of temperature are input, correction coefficients may be obtained based on a multivariate normal distribution. In the case of FIG. 8, it is assumed that arbitrary mean/variance values of SOC and temperature were applied. As illustrated in FIG. 8, the three-dimensional graph is prepared based on the temperature ranging from - 10°C to 45°C and the SOC ranging from 0 to 100%, with the assumption that the correction coefficients were also extracted based on these criteria. Meanwhile, the method of obtaining the correction coefficients is not limited to this and may, for example, be determined using other types of distributions.

According to an embodiment, the controller 130 of the battery management system 100 may generate a correction coefficient map 800 using Equation 1 below. Equation 1 may be a function related to a probability density of a bivariate normal distribution. Here, the bivariate may be the first parameter and the second parameter.

<Equation 1>

$$f(X) = \frac{1}{2\pi\sqrt{\sigma_1 \sigma_2}} \times exp\left\{-\frac{1}{2}\left[\left(\frac{x_1 - u_1}{\sqrt{\sigma_1}}\right)^2 + \left(\frac{x_2 - u_2}{\sqrt{\sigma_2}}\right)^2 - 2\rho\left(\frac{x_1 - u_1}{\sqrt{\sigma_1}}\right)\left(\frac{x_2 - u_2}{\sqrt{\sigma_2}}\right)\right]\right\}$$

In Equation 1, $X = \{x_1 : x_2\}$, where $x_1$ is the index value of the first parameter associated with the map value to be updated, and $x_2$ is the index value of the second parameter associated with the map value to be updated, $u_1$ is $P_{1\_i}$, $u_2$ is $P_{2\_j}$, and f(X) is a correction coefficient.

In addition, $\sigma_1$ may be a predetermined standard deviation for the first parameter, and $\sigma_2$ may be a predetermined standard deviation for the second parameter. For example, considering that the variability of internal resistance due to changes in SOC is not large, whereas the variability of internal resistance due to changes in temperature is relatively large, $\sigma_1$ may be set to be larger than $\sigma_2$.

For the update of the parameter map 200, the target correction coefficient ($W_{i,j}$), to be multiplied by the target deviation ($\Delta R_{i,j}$), may be the result value (f(X)), when the two latest values ($P_{1\_i}$, $P_{2\_j}$) of the first parameter and second parameter are respectively input as $x_1$ and $x_2$ in Equation 1.

The controller 130 of the battery management system 100 may determine the expansion correction coefficient ($W_{a,b}$) based on the latest value ($P_{1\_i}$) of the first parameter, the index value ($P_{1\_a}$) of the first parameter associated with the expansion map value, the latest value ($P_{2\_j}$) of the second parameter, and the index value ($P_{2\_b}$) of the second parameter associated with the expansion map value.

The expansion correction coefficient ($W_{a,b}$) may be the result value (f(X)) when the two values ($P_{1\_a}$, $P_{2\_b}$) of another pair that are different from at least one of the two latest values ($P_{1\_i}$, $P_{2\_j}$) of the first and second parameters are respectively input as $x_1$ and $x_2$ in Equation 1.

For example, it is assumed that $P_{3\_i,j}$ is 0.02[$\Omega$], $R_{i,j}$ is 0.0166[$\Omega$], $W_R$ is 0.2, and $W_{i,j}$ is 1. Then, $R_{i,j}' = R_{i,j} + C_{i,j} = R_{i,j} + W_R \times W_{i,j} \times (P_{3\_i,j} - R_{i,j}) \fallingdotseq 0.0173$[$\Omega$].

As another example, it is assumed that $R_{i,j}'$ is 0.0173[$\Omega$], $R_{a,b}$ is 0.0167[$\Omega$], $W_R$ is 0.2, and $W_{a,b}$ is 0.1353. Then, $R_{a,b}' = R_{a,b} + C_{a,b} = R_{a,b} + W_R \times W_{a,b} \times (P_{3\_i,j} - R_{i,j}') \fallingdotseq 0.0168$[$\Omega$].

According to an embodiment, the controller 130 of the battery management system 100 may determine each of all storage locations, except for the target storage location, among the first to MN-th storage locations, as an expansion storage location. Alternatively, among the first to MN-th storage locations, the controller 130 may determine each storage location, where the distance from the target storage location is less than or equal to a predetermined threshold distance, as an expansion storage location. An equation for calculating the distance between two points may be used to calculate the distance between any two storage locations. For example, the distance between (S#1, T#3) and (S#2, T#1) = {(index number of S#1 - index number of S#2)$^2$ + (index number of T#3 - index number of T#1)$^2$}$^{1/2}$ = {(1 - 2)$^2$ + (3 - 1)$^2$}$^{1/2}$ = $5^{1/2}$.

When updating a map value recorded at an expansion storage location, the expansion correction coefficient ($W_{a,b}$) may have a certain negative correlation with the difference in distance between the target storage location and the expansion storage location. For example, the controller 130 may determine the expansion correction coefficient ($W_{a,b}$) based on the distance difference between the target storage location and the expansion storage location, when updating the expansion map value recorded at any expansion storage location. In this case, unlike the aforementioned scenario, the expansion correction coefficient ($W_{a,b}$) may be a value modified by the controller 130.

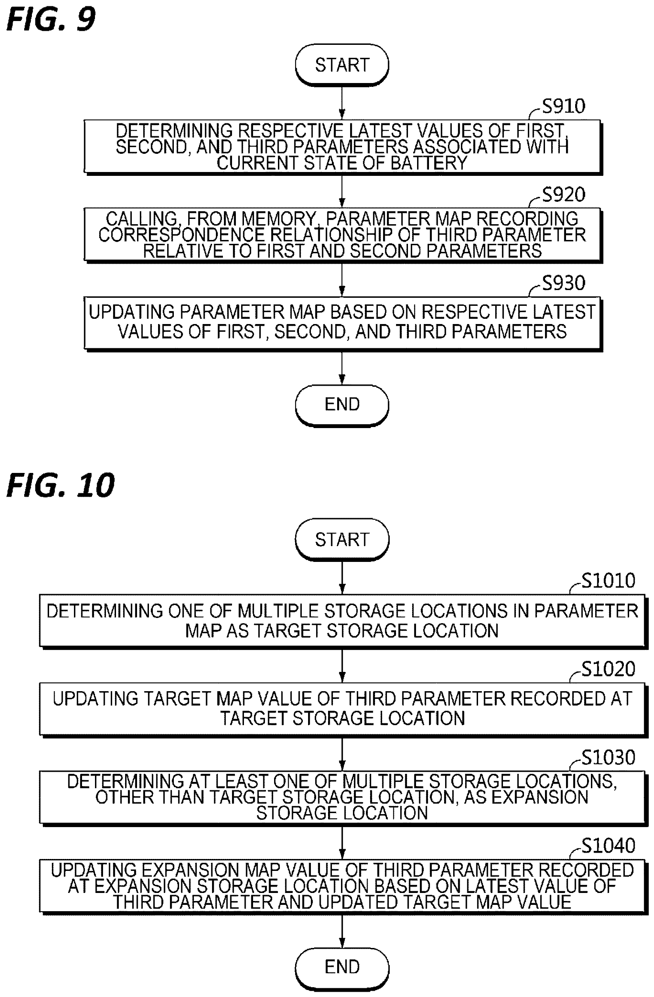

FIG. 9 is a flowchart schematically illustrating a battery management method according to another embodiment of the present disclosure.

Referring to FIG. 9, in step S910, the controller 130 of the battery management system 100 executes a parameter acquisition procedure to determine the latest values ($P_{1\_i}$, $P_{2\_j}$, $P_{3\_i,j}$) of the first parameter (e.g., SOC), the second parameter (e.g., temperature), and the third parameter (e.g., internal resistance), each associated with the current state of the battery B. For example, the latest value ($P_{1\_i}$) of the first parameter may be obtained through a measurement operation for the first parameter of the battery B, and the latest values ($P_{2\_j}$, $P_{3\_i,j}$) of each of the second and third parameters may be obtained, respectively, by applying a predetermined mathematical function to the time series of measurements over a certain period for the first parameter and/or other parameters.

In step S920, the controller 130 of the battery management system 100 calls (reads) the parameter map 200 from the memory 140, in which the correspondence relationship of the third parameter relative to the first and second parameters is recorded. For example, the controller 130 may read the parameter map 200 illustrated in FIG. 2 from the memory 140.

In step S930, the controller 130 executes a map update procedure and updates the parameter map 200 based on respective latest values ($P_{1\_i}$, $P_{2\_j}$, $P_{3\_i,j}$) of the first, second, and third parameters, obtained in the previous step (*e.g.,* S910), in accordance with the update logic described above.

FIG. 10 is a flowchart schematically illustrating subroutines that may be executed in step S930 of FIG. 9.

Referring to FIG. 10, in step S1010, the controller 130 of the battery management system 100 determines one of the multiple storage locations in the parameter map 200 as the target storage location, based on the respective latest values ($P_{1\_i}$, $P_{2\_j}$) of the first and second parameters.

In step S1020, the controller 130 updates the target map value ($R_{i,j}$) of the third parameter recorded at the target storage location, based on the latest value of the third parameter obtained in the previous step.

In step S1030, among the multiple storage positions, the controller 130 determines at least one of the storage locations, other than the target storage location, as an expansion storage location. For example, referring to FIG. 7, the controller 130 of the battery management system 100 may determine the ab-th storage location, different from the ij-th storage location as the expansion storage location.

In step S1040, the controller 130 updates the expansion map value ($R_{a,b}$) of the third parameter recorded at the expansion storage location, based on the latest value of the third parameter and the target map value ($R_{i,j}'$) updated in step S1020. For example, referring to FIG. 7, the controller 130 may determine the updated expansion map value ($R_{a,b}'$) by summing the expansion map value ($R_{a,b}$) and the expansion correction value ($C_{a,b}$). As a result, the map value recorded at the ab-th storage location in the parameter map 200 may be updated from $R_{a,b}$ to $R_{a,b}'$.

Through the process described above, the parameter map used for determining a specific parameter may be updated based on the value of a specific parameter determined by the parameter determination logic. In addition, when executing an update procedure for a parameter map related to a specific parameter, not only the specific map value of the parameter map mapped to the latest values of other parameters but also at least one other map value recorded in the parameter map may be expansively updated.

The above-described embodiments of the present disclosure are not limited to being implemented solely through apparatuses and methods, but may also be implemented through a program that realizes the functions corresponding to the configuration of the embodiments of the present disclosure or through a recording medium on which such a program is recorded. This may be readily implemented by a person ordinarily skilled in the technical field to which the present disclosure belongs based on the description of the embodiments described above.

In this specification, directional terms such as up, down, left, right, front, and rear are used, but it is obvious to a person ordinarily skilled in the art that these terms are for convenience of description only and may vary depending on, for example, the location of an object thing or the position of an observer.

The above-described embodiments of the present disclosure are not only implemented through apparatuses and methods, but may also be implemented through a program that implements the functions corresponding to the configuration of the embodiment of the present disclosure or a recording medium recorded with the program. This may be easily implemented by a person ordinarily skilled in the technical field to which the present disclosure belongs based on the description of the embodiments described above.

**Claims**

1. A battery management system comprising:

    a memory; and
    a controller configured to execute a parameter acquisition procedure to determine respective latest values of first, second, and third parameters associated with a current state of a battery,
    wherein the controller is further configured to:

    call, from the memory, a parameter map recording a correspondence relationship of the third parameter relative to the first and second parameters; and
    execute a map update procedure to update the parameter map based on the respective latest values of the first, second, and third parameters.

2. The battery management system of claim 1, wherein the controller is further configured to:

    determine one of multiple storage locations in the parameter map as a target storage location, based on the respective latest values of the first and second parameters; and
    update a target map value of the third parameter recorded at the target storage location, based on the latest value of the third parameter.

3. The battery management system of claim 2, wherein the controller is further configured to:

    determine a target correction value based on a difference between the latest value of the third parameter and the target map value; and
    update the target map value by summing the target correction value with the target map value.

4. The battery management system of claim 3, wherein the controller is further configured to:
   determine the target correction value by multiplying a reference coefficient and a target correction coefficient by the difference between the latest value of the third parameter and the target map value.

5. The battery management system of claim 4, wherein the reference coefficient and the target correction coefficient are each a predetermined positive number.

6. The battery management system of claim 2, wherein the controller is further configured to:

   determine at least one of the multiple storage locations, other than the target storage location, as an expansion storage location; and
   update an expansion map value of the third parameter recorded at the expansion storage location based on the latest value of the third parameter and the updated target map value.

7. The battery management system of claim 6, wherein the controller is further configured to:

   determine an expansion correction value based on a difference between the latest value of the third parameter and the updated target map value; and
   update the expansion map value by summing the expansion correction value with the expansion map value.

8. The battery management system of claim 7, wherein the controller is further configured to:
   determine the expansion correction value by multiplying a reference coefficient and an expansion correction coefficient by the difference between the latest value of the third parameter and the updated target map value.

9. The battery management system of claim 8, wherein the controller is further configured to:
   determine the expansion correction coefficient based on the latest value of the first parameter, an index value of the first parameter associated with the expansion map value, the latest value of the second parameter, and an index value of the second parameter associated with the expansion map value.

10. The battery management system of claim 1, wherein the first parameter is a state of charge (SOC), the second parameter is temperature, and the third parameter is internal resistance.

11. A battery pack comprising the battery management system of claim 1.

12. An electric vehicle comprising the battery pack of claim 11.

13. A battery management method comprising:

   executing a parameter acquisition procedure to determine respective latest values of a first parameter, a second parameter, and a third parameter associated with a current state of a battery;
   calling, from a memory, a parameter map recording a correspondence relationship of the third parameter relative to the first and second parameters; and
   executing a map update procedure to update the parameter map based on the respective latest values of the first, second, and third parameters.

14. The battery management method of claim 13, wherein the updating the parameter map includes:

   determining one of multiple storage locations in the parameter map as a target storage location, based on the respective latest values of the first and second parameters; and
   updating a target map value of the third parameter recorded at the target storage location, based on the latest value of the third parameter.

15. The battery management method of claim 14, wherein the updating the parameter map includes:

   determining at least one of the multiple storage locations, other than the target storage location, as an expansion storage location; and
   updating an expansion map value of the third parameter recorded at the expansion storage location based on the latest value of the third parameter and the updated target map value.

16. A non-transitory computer-readable storage medium storing a program that when executed, causes a system to execute a method comprising:

storing, in a memory, a parameter map recording a correspondence relationship of a third parameter relative to a first parameter and a second parameter of a battery;

executing a parameter acquisition procedure to determine respective latest values of the first parameter, the second parameter, and the third parameter associated with a current state of the battery;

calling the parameter map from the memory; and

updating the parameter map based on the respective latest values of the first, second, and third parameters.

17. The storage medium of claim 16, wherein the updating the parameter map includes:

determining one of multiple storage locations in the parameter map as a target storage location, based on the respective latest values of the first and second parameters; and

updating a target map value of the third parameter recorded at the target storage location, based on the latest value of the third parameter.

18. The storage medium of claim 17, wherein the updating the parameter map includes:

determining a target correction value based on a difference between the latest value of the third parameter and the target map value; and

updating the target map value by summing the target correction value with the target map value.

# FIG. 1

# FIG. 2

**200**

| INTERNAL RESISTANCE [Ω] | | SOC [%] | | | | | |
|---|---|---|---|---|---|---|---|
| | | S#1 | S#2 | .... | S#i | .... | S#M |
| TEMPERATURE [°C] | T#1 | $R_{1,1}$ | $R_{2,1}$ | .... | $R_{i,1}$ | .... | $R_{M,1}$ |
| | T#2 | $R_{1,2}$ | $R_{2,2}$ | .... | $R_{i,2}$ | .... | $R_{M,2}$ |
| | .... | .... | .... | .... | .... | .... | .... |
| | T#j | $R_{1,j}$ | $R_{2,j}$ | .... | $R_{i,j}$ | .... | $R_{M,j}$ |
| | .... | .... | .... | .... | .... | .... | .... |
| | T#N | $R_{1,N}$ | $R_{2,N}$ | .... | $R_{i,N}$ | .... | $R_{M,N}$ |

## FIG. 3

## FIG. 4

**FIG. 5**

**FIG. 6**

## FIG. 7

$$P_{3\_i,j}$$
$$R_{i,j}'$$
$$\longrightarrow (-) \longrightarrow \Delta R_{i,j}' \longrightarrow (\times) \longleftarrow W_{a,b}$$

$$W_R$$

$$C_{a,b}$$

$$R_{a,b} \longrightarrow (+) \longrightarrow R_{a,b}'$$

## FIG. 8

800

CORRECTION
COEFFICIENT

1

0
-45

SECOND PARAMETER
(TEMPERATURE[°C])

-10  0

FIRST PARAMETER
(SOC[%])

100

## FIG. 9

START

↓

*S910*

DETERMINING RESPECTIVE LATEST VALUES OF FIRST, SECOND, AND THIRD PARAMETERS ASSOCIATED WITH CURRENT STATE OF BATTERY

↓

*S920*

CALLING, FROM MEMORY, PARAMETER MAP RECORDING CORRESPONDENCE RELATIONSHIP OF THIRD PARAMETER RELATIVE TO FIRST AND SECOND PARAMETERS

↓

*S930*

UPDATING PARAMETER MAP BASED ON RESPECTIVE LATEST VALUES OF FIRST, SECOND, AND THIRD PARAMETERS

↓

END

## FIG. 10

START

↓

*S1010*

DETERMINING ONE OF MULTIPLE STORAGE LOCATIONS IN PARAMETER MAP AS TARGET STORAGE LOCATION

↓

*S1020*

UPDATING TARGET MAP VALUE OF THIRD PARAMETER RECORDED AT TARGET STORAGE LOCATION

↓

*S1030*

DETERMINING AT LEAST ONE OF MULTIPLE STORAGE LOCATIONS, OTHER THAN TARGET STORAGE LOCATION, AS EXPANSION STORAGE LOCATION

↓

*S1040*

UPDATING EXPANSION MAP VALUE OF THIRD PARAMETER RECORDED AT EXPANSION STORAGE LOCATION BASED ON LATEST VALUE OF THIRD PARAMETER AND UPDATED TARGET MAP VALUE

↓

END

# INTERNATIONAL SEARCH REPORT

| International application No. |
|---|
| **PCT/KR2024/013676** |

| A. | CLASSIFICATION OF SUBJECT MATTER |
|---|---|

**G01R 31/367**(2019.01)i; **G01R 31/36**(2006.01)i; **G01R 31/392**(2019.01)i; **G01R 31/396**(2019.01)i; **G01R 31/385**(2019.01)i; **H01M 10/42**(2006.01)i; **H01M 10/48**(2006.01)i; **B60L 58/16**(2019.01)i

According to International Patent Classification (IPC) or to both national classification and IPC

| B. | FIELDS SEARCHED |
|---|---|

Minimum documentation searched (classification system followed by classification symbols)

G01R 31/367(2019.01); B60L 11/18(2006.01); B60L 50/60(2019.01); B60L 58/16(2019.01); G01R 31/36(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 파라미터(parameter), 업데이트(update), 맵(map), 배터리(battery), 편차(deviation)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | KR 10-2018-0082020 A (HANWHA LAND SYSTEMS CO., LTD.) 18 July 2018 (2018-07-18) See paragraphs [0002] and [0019]-[0051] and claim 1. | 1,2,6,10-17 |
| A | | 3-5,7-9,18 |
| A | KR 10-2016-0090292 A (SONY CORPORATION) 29 July 2016 (2016-07-29) See paragraph [0042]. | 1-18 |
| A | KR 10-2023-0019315 A (HYUNDAI MOTOR COMPANY et al.) 08 February 2023 (2023-02-08) See paragraph [0084]. | 1-18 |
| A | KR 10-2014-0093552 A (LG INNOTEK CO., LTD.) 28 July 2014 (2014-07-28) See paragraph [0032]. | 1-18 |
| A | US 2016-0096443 A1 (VOLVO CAR CORPORATION) 07 April 2016 (2016-04-07) See paragraphs [0058]-[0060]. | 1-18 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **11 December 2024** | **11 December 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/013676**

| Patent document cited in search report | | | Publication date (day/month/year) | Patent family member(s) | | | Publication date (day/month/year) |
|---|---|---|---|---|---|---|---|
| KR | 10-2018-0082020 | A | 18 July 2018 | KR | 10-2350920 | B1 | 13 January 2022 |
| KR | 10-2016-0090292 | A | 29 July 2016 | CA | 2931084 | A1 | 28 May 2015 |
| | | | | EP | 3076518 | A1 | 05 October 2016 |
| | | | | EP | 3076518 | A4 | 26 July 2017 |
| | | | | EP | 3076518 | B1 | 24 June 2020 |
| | | | | JP | 2015-104225 | A | 04 June 2015 |
| | | | | KR | 10-2141268 | B1 | 04 August 2020 |
| | | | | US | 10523029 | B2 | 31 December 2019 |
| | | | | US | 2016-0254680 | A1 | 01 September 2016 |
| | | | | WO | 2015-075857 | A1 | 28 May 2015 |
| KR | 10-2023-0019315 | A | 08 February 2023 | US | 11852690 | B2 | 26 December 2023 |
| | | | | US | 2023-0030372 | A1 | 02 February 2023 |
| KR | 10-2014-0093552 | A | 28 July 2014 | KR | 10-1996943 | B1 | 01 October 2019 |
| US | 2016-0096443 | A1 | 07 April 2016 | CN | 105487013 | A | 13 April 2016 |
| | | | | CN | 105487013 | B | 21 April 2020 |
| | | | | EP | 3002598 | A1 | 06 April 2016 |
| | | | | EP | 3002598 | B1 | 14 August 2019 |
| | | | | US | 10457154 | B2 | 29 October 2019 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230154782

- KR 1020240122639